Europäisches Patentamt

European Patent Office

Office européen des brevets

(11) Numéro de publication : **0 501 850 A1**

# (12) DEMANDE DE BREVET EUROPEEN

(21) Numéro de dépôt : **92400423.7**

(51) Int. Cl.$^5$ : **H01F 15/02, H01F 15/10**

(22) Date de dépôt : **18.02.92**

(30) Priorité : **01.03.91 FR 9102470**

(43) Date de publication de la demande :
**02.09.92 Bulletin 92/36**

(84) Etats contractants désignés :
**BE DE ES FR GB IT NL**

(71) Demandeur : **COMPAGNIE EUROPEENNE DE COMPOSANTS ELECTRONIQUES LCC
50, rue Jean-Pierre Timbaud
F-92400 Courbevoie (FR)**

(72) Inventeur : **Putigny, Jean-Jacques
THOMSON-CSF, SCPI, Cédex 67
F-92045 Paris la Défense (FR)**
Inventeur : **Gaudry, Pierre
THOMSON-CSF, SCPI, Cédex 67
F-92045 Paris la Défense (FR)**

(74) Mandataire : **Ruellan-Lemonnier, Brigitte et al
THOMSON-CSF SCPI
F-92045 PARIS LA DEFENSE CEDEX 67 (FR)**

(54) **Composant magnétique pour le report à plat.**

(57) La présente invention concerne un composant magnétique pour le report à plat.

Ce composant est constitué par un premier noyau magnétique 1 électriquement isolé sur lequel est bobiné directement au moins un enroulement électrique 8, 9 dont les extrémités sont reliées chacune à une connexion métallique 11 permettant le report à plat, fixée sur ledit noyau magnétique.

Application notamment aux transformateurs pour le report à plat.

FIG.2

EP 0 501 850 A1

La présente invention concerne un composant magnétique pour le report à plat, plus particulièrement un transformateur reportable à plat.

Actuellement, dans l'industrie des composants électroniques, la plupart des composants actifs et passifs sont disponibles sous une forme qui permet leur report à plat sur les circuits imprimés. De tels composants sont habituellement dénommés "chips". Ces composants ont des dimensions particulièrement réduites, ce qui permet leur intégration dans des circuits électroniques avec une densité très importante. Toutefois, les composants magnétiques, en particulier les transformateurs, n'ont pas encore évolués dans ce sens. Aussi, dans la plupart des alimentations de puissance, par exemple, le composant le plus encombrant reste le transformateur.

Ainsi, les transformateurs utilisés dans les alimentations de puissance sont constitués essentiellement d'une carcasse de bobinage sur laquelle sont bobinés un ou plusieurs enroulements électriquement séparés, cette carcasse de bobinage étant munie d'un trou axial pour le passage des noyaux magnétiques. Dans les alimentations de puissance, le noyau magnétique présente une section effective importante proportionnelle à la puissance à transmettre. De ce fait, la hauteur relative du composant magnétique utilisé comme transformateur ne permet pas une grande intégration des cartes électroniques sur lesquelles il est monté.

Actuellement, pour permettre le montage en surface de ce type de transformateurs, la technique utilisée consiste à transformer la carcasse servant au support des bobinages. De ce fait, les picots qui habituellement traversent les circuits imprimés, sont transformés, le plus souvent cambrés, pour obtenir des connexions radiales. Toutefois, le transformateur final reste de dimensions non négligeables. En particulier il présente une hauteur importante à cause de son volume sensiblement cubique.

La présente invention a pour but de remédier aux inconvénients ci-dessus en proposant un nouveau composant magnétique pour le report à plat qui ne comporte plus de carcasse de bobinage.

La présente invention a aussi pour but de proposer un nouveau composant magnétique pour le report à plat présentant une hauteur particulièrement réduite, à savoir inférieure à 10 mm.

En conséquence, la présente invention a pour objet un composant magnétique pour le report à plat, caractérisé en ce qu'il est constitué par un premier noyau magnétique électriquement isolé sur lequel est bobiné directement au moins un enroulement électrique dont les extrémités sont reliées chacune à une connexion métallique permettant le report à plat, fixée sur ledit noyau magnétique.

Selon un mode de réalisation préférentiel, le premier noyau magnétique comporte un mandrin central sur lequel est bobiné au moins un enroulement électrique, ledit mandrin étant compris entre deux flasques latéraux de telle sorte que le premier noyau magnétique présente une section longitudinale sensiblement en forme de I.

D'autre part, le composant magnétique pour le report à plat étant principalement utilisé comme transformateur dans les circuits de puissance, de préférence le circuit magnétique est réalisé en ferrite doux, à savoir un ferrite à base d'oxyde de fer ($Fe_2O_3$), de manganèse ($Mn_3O_4$) et de zinc (ZnO). Malgré une structure polycristalline à joints de grains isolants, ce matériau magnétique présente une résistivité relativement faible permettant une certaine conduction du courant électrique par le circuit magnétique. De ce fait, selon une autre caractéristique de la présente invention, pour garantir une bonne rigidité diélectrique entre les enroulements et le circuit, le premier circuit magnétique est revêtu d'une couche isolante.

Selon un premier mode de réalisation, la couche isolante est réalisée par un émaillage en verre.

Selon un second mode de réalisation, la couche isolante est réalisée par dépôt d'une couche d'un matériau époxy.

Selon une caractéristique supplémentaire de la présente invention permettant une meilleure fixation des connexions métalliques pour le report à plat sur le premier noyau magnétique, les surfaces latérales ou les surfaces inférieures des flasques du premier noyau magnétique sont munies de terminaisons conductrices permettant la fixation des connexions métalliques sur le noyau magnétique. Dans ce cas, la fixation des connexions métalliques sur le premier noyau magnétique est effectuée par soudage sur les terminaisons conductrices.

Selon encore une autre caractéristique de la présente invention, le composant magnétique comporte de plus un deuxième noyau magnétique électriquement isolé pour fermer le champ magnétique avec ou sans entrefer.

D'autres caractéristiques et avantages de la présente invention apparaîtront à la lecture de la description de différents modes de réalisation d'un composant magnétique pour le report à plat, cette description étant faite avec référence aux dessins ci-annexés dans lesquels :

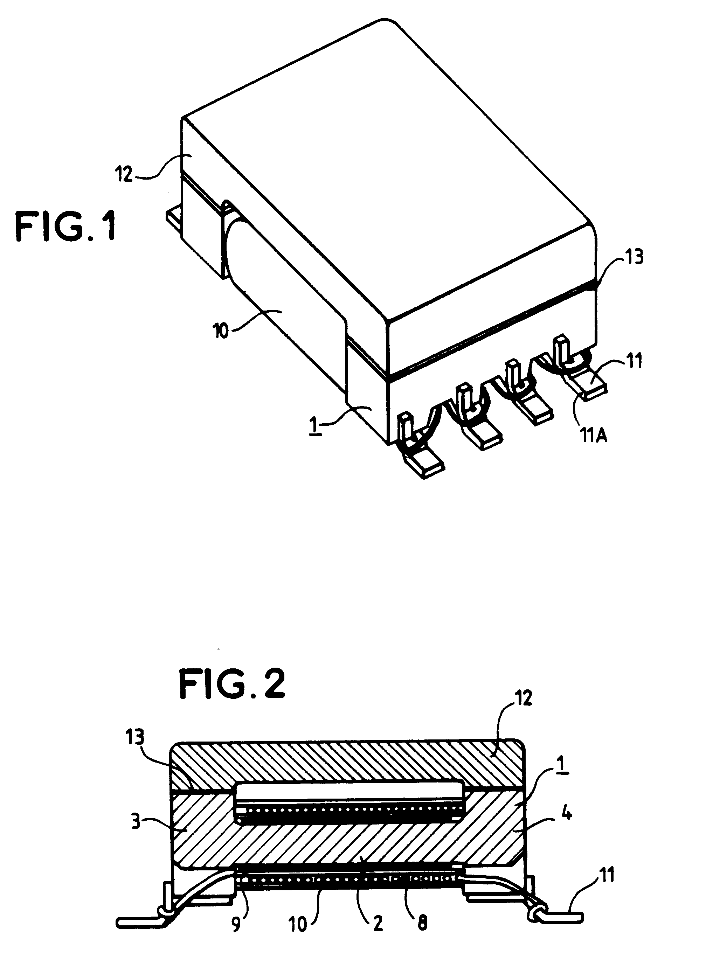

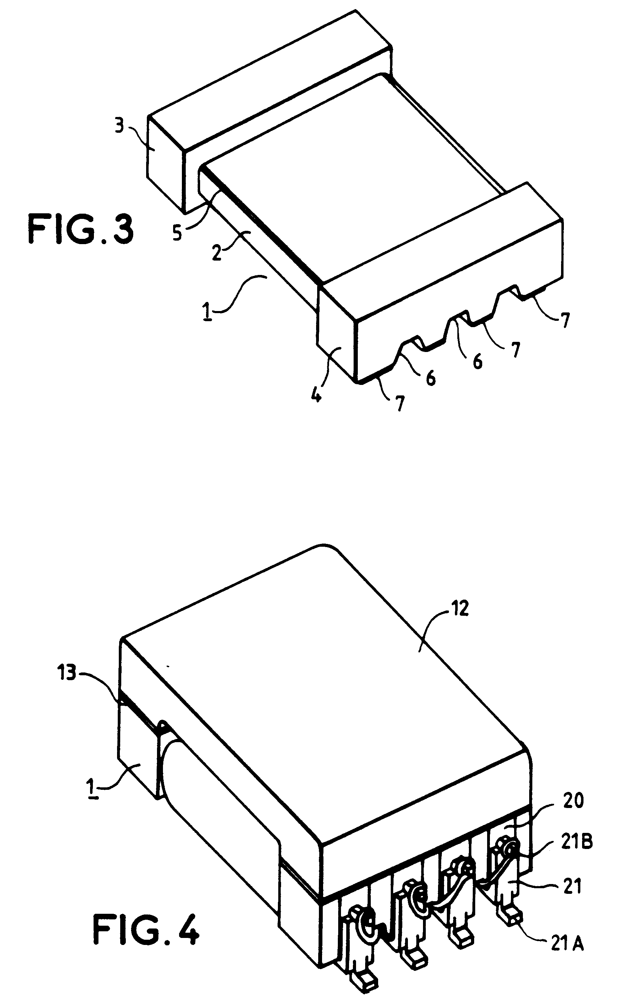

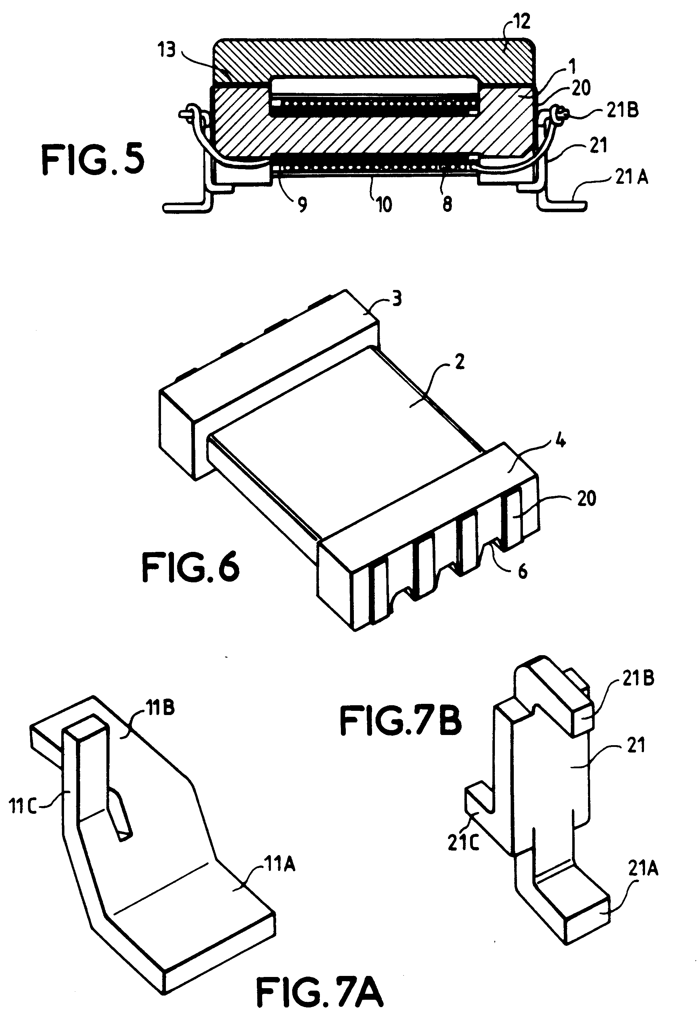

  − la figure 1 est une vue en perspective d'un premier mode de réalisation d'un transformateur de puissance pour le report à plat conforme à la présente invention ;
  − la figure 2 est une vue en coupe du transformateur de figure 1 ;
  − la figure 3 est une vue en perspective du premier noyau magnétique du transformateur ;
  − la figure 4 est une vue en perspective d'un seconde mode de réalisation d'un transformateur de puissance pour le report à plat conforme à la présente invention ;
  − la figure 5 est une vue en coupe du transformateur de figure 4 ;

– la figure 6 est une vue en perspective du premier noyau magnétique du transformateur de figure 4 ; et

– les figures 7A et 7B sont des vues en perspective des connexions métalliques utilisées respectivement pour le transformateur de la figure 1 et de la figure 4.

La présente invention sera décrite en se référant à des transformateurs de puissance permettant le report à plat. Toutefois, il est évident pour l'homme de l'art que la présente invention peut s'appliquer à d'autres types de composants magnétiques pour le report à plat.

D'autre part, pour simplifier la description, dans les figures les mêmes éléments portent les mêmes références.

On décrira tout d'abord, avec références aux figures 1, 2, 3 et 7A, un premier mode de réalisation d'un transformateur de puissance permettant le report à plat ou transformateur de type CMS conforme à la présente invention. Comme représenté sur les figures 1 à 3, le transformateur conforme à la présente invention est constitué essentiellement d'un premier noyau magnétique 1. Ce premier noyau magnétique 1 comporte un mandrin central 2 compris entre deux flasques latéraux 3, 4. Ce premier noyau magnétique, qui peut être obtenu par pressage, moulage, usinage ou similaire, est réalisé en ferrite doux. De préférence, dans les applications de puissance les ferrites utilisés présentent une composition à base de fer (Fe), de manganèse (Mn) et de zinc (Zn), plus particulièrement à base d'oxyde de fer ($Fe_2O_3$), de manganèse ($Mn_3O_4$) et de zinc (ZnO). Cette composition a pour principal avantage d'avoir des pertes faibles et une induction à saturation élevée. Toutefois, ce type de ferrite présente une résistivité relativement faible, à savoir :

$\rho < 102 \ \Omega$ m. Cette résistivité permet une certaine conduction du courant électrique par e noyau magnétique. En conséquence, ce premier noyau magnétique doit être isolé électriquement. Il faut donc réaliser un isolement de la surface du noyau magnétique pour garantir une bonne rigidité diélectrique entre les enroulements et le noyau. Comme représenté sur la figure 3, cet isolement est réalisé par une couche d'isolement 5. Cette couche d'isolement peut être obtenue de différentes manières. Selon une première technique, cette couche d'isolement est obtenue par dépôt d'une couche de verre, ce dépôt étant suivi d'une refusion à une température d'environ 800°C. Cette technique permet d'obtenir une très bonne stabilité du composant par rapport au choc thermique lors d'une opération de soudage. Une seconde technique retenue pour l'isolation est le dépôt d'une couche époxy, ce dépôt étant polymérisé à une température d'environ 150°C. Ce dépôt présente l'avantage d'être plus simple à mettre en oeuvre. Toutefois, lorsque l'on réalise le soudage des connexions, comme cela sera expliqué ci-après, il ne faut pas surchauffer la pièce afin de ne pas dégrader la matière isolante.

D'autre part, comme représenté sur la figure 3, les flasques 3 et 4 sont munis d'encoches 6 qui permettent le passage des enroulements sans accroître la dimension totale du composant. De plus, dans le mode de réalisation des figures 1 à 3, les flasques 3 et 4 sont munis sur leur surface inférieure de terminaisons conductrices 7 permettant la fixation des connexions métalliques. Les terminaisons conductrices sont réalisées avec une pâte conductrice dont la composition dépend de la constitution de la couche isolante 5. Ainsi, lorsque la couche isolante 5 est obtenue par émaillage, les terminaisons sont réalisées avec une pâte conductrice traitée à haute température, par exemple une pâte conductrice à base d'argent et de palladium ou une pâte conductrice à base de cuivre. Lorsque la couche 5 est une couche à base de poudre époxy, les connexions métalliques seront fixées par collage utilisant des colles de type epoxy de même nature que celle utilisée pour l'isolation.

Comme représenté plus particulièrement sur la figure 2, autour du mandrin central 2 du premier noyau magnétique 1 est bobiné au moins un enroulement électrique, à savoir deux enroulements électriques 8, 9 constituant le primaire et le secondaire du transformateur dans le mode de réalisation représenté. Dans ce cas, les enroulements sont bobinés de manière à former deux couches superposées. Cette répartition en couches sur toute la longueur du mandrin central 2 permet de réduire la hauteur totale du circuit. D'autre part, comme représenté sur la figure 2, les enroulements sont isolés par une couche d'isolement 10.

Pour permettre le montage à plat du transformateur décrit ci-dessus, le premier noyau magnétique 1 est muni de connexions métalliques 11 permettant le report à plat. En effet, les ferrites utilisés possèdent un coefficient de dilatation linéaire très faible comparativement à ceux des circuits imprimés. Il existe donc un risque de cisaillement des soudures lors des divers cycles de températures. Il n'est donc pas possible de connecter directement par l'intermédiaire des terminaisons du circuit magnétique sur le circuit imprimé en utilisant les techniques connues de soudure à la vague ou similaire. Conformément à la présente invention et comme représenté sur les figures 1 et 2, on utilise des connexions métalliques 11, qui sont soudées sur des terminaisons conductrices 7 ou collées selon la constitution de la couche isolante 5 sur le premier noyau magnétique. Dans le cas du mode de réalisation représenté, les terminaisons conductrices sont prévues sur la surface inférieure des flasques 3 et 4 du premier noyau magnétique 1 et de ce fait les connexions métalliques 11 doivent pouvoir se souder sur lesdites terminaisons. Les connexions métalliques présentent donc une forme telle que représentée sur la figure 7A. Elles sont donc constituées par une plaque rectangulaire qui a été découpée et courbée de manière à présenter deux extrémités 11A et 11B sensiblement horizontales et une patte 11C verticale permettant une meilleure fixation des connexions sur le premier circuit magnétique. Comme représenté sur les figures 1 et 2, cette connexion métallique reçoit les extrémités des fils constituant les enroulements. Ces extrémités sont fixées de manière connue par soudage sur la connexion métallique 11. D'autre part, les connexions métalliques réalisent la tenue mécanique du composant soudé et la liaison électrique entre les enroulements et la piste du circuit imprimé. Les dilatations linéaires différentielles entre le composant et le circuit imprimé sont absorbées par l'élasticité des connexions métalliques 11.

D'autre part, comme représenté sur les figures 1 et 2, le champ magnétique du transformateur est fermé par un second noyau magnétique 12 qui est réalisé en un matériau en ferrite doux comme le premier noyau magnétique. Ce second noyau est aussi isolé électriquement. Il est collé sur les surfaces supérieures des deux flasques 3 et 4, de manière à assurer la circulation du flux magnétique. Un entrefer variable 13 est aménagé à l'aide de câles disposés sur les deux flasques 3 et 4 afin de pouvoir ajuster les propriétés magnétiques de perméabilité et d'induction demandées par l'application. Ainsi, le transformateur réalisé ci-dessus n'utilise plus de carcasse comme support des fils de bobinage, ceux-ci étant montés directement sur le circuit magnétique. Il est donc possible d'utiliser un composant dont la hauteur totale est inférieure à 10mm et qui soit de plus compatible avec la technologie du montage en surface, les connexions métalliques présentant des pattes 11A parallèles à la surface de montage.

On décrira maintenant, avec référence aux figures 4, 5, 6 et 7B, un autre mode de réalisation d'un transformateur conforme à la présente invention. Dans ce cas, les connexions sont reportées sur les faces latérales du noyau magnétique. On ne redécrira pas la structure complète du premier noyau magnétique 1 qui est identique à celle du transformateur décrit avec référence aux figures 1 et 3. Dans ce cas, la seule différence réside dans le fait que les terminaisons conductrices 20 sont déposées sur les surfaces latérales des flasques 3 et 4, comme représenté clairement sur les figures 4 à 6. Sur ces terminaisons conductrices 20 sont soudées ou collées selon la constitution de la couche isolante 5 des connexions métalliques 21 permettant le montage en surface. De telles connexions métalliques sont représentées en perspective sur la figure 7B. Elles sont constituées par une plaque rectangulaire qui a été découpée et pliée de la manière représentée à la figure 7B. Chaque connexion comporte donc deux pattes 21A et 21B pliées à 90° dans la même direction par rapport à la partie centrale 21. Cette partie centrale 21 vient se souder ou se coller sur la terminaison conductrice 20. La patte 21A est utilisée pour le montage sur le circuit imprimé tandis que la patte 21B sert au wrapping de l'extrémité d'un des enroulements, comme représenté clairement sur les figures 4 et 5. D'autre part, pour faciliter le maintien en position des connexions, des pattes 21C ont ainsi été décomposées de chaque côté de la patte 21A et sont aussi cambrées à 90° par rapport à la plaque 21 mais dans la direction opposée à la patte 21A de manière à venir se positionner contre la surface inférieure des flasques 3 et 4, comme représenté clairement sur la figure 5.

De manière connue et déjà décrite avec référence aux figures 1, 2 et 3, un enroulement primaire et un enroulement secondaire ont été bobinés autour du mandrin central 2 de forme parallélépipèdique, ces bobinages étant isolés par une couche d'isolement 10. De plus, le circuit magnétique est fermé par une plaque 12 réalisée de manière identique à la plaque 12 déjà décrite. Cette plaque 12 est collée sur les flasques 3 et 4 avec interposition d'un entrefer 13 dont la hauteur peut être réglable.

Les modes de réalisation ci-dessus permettent d'obtenir des composants magnétiques, plus particulièrement des transformateurs de hauteur relativement réduite en supprimant la carcasse de bobinage et en prévoyant sur le noyau magnétique la fixation de connexions compatibles CMS.

## Revendications

1. Composant magnétique pour le report à plat, caractérisé en ce qu'il est constitué par un premier noyau magnétique (1) électriquement isolé (5) sur lequel est bobiné directement au moins un enroulement électrique (8,9) dont les extrémités sont reliées chacune à une connexion métallique (11,21) permettant le report à plat, fixée sur ledit noyau magnétique.

2. Composant magnétique selon la revendication 1, caractérisé en ce que le premier noyau magnétique comporte un mandrin central (2) sur lequel est bobiné au moins un enroulement électrique, ledit mandrin étant compris entre deux flasques latéraux (3, 4).

3. Composant magnétique selon la revendication 2, caractérisé en ce que le premier noyau magnétique présente une section longitudinale sensiblement en forme de I.

4. Composant magnétique selon l'une quelconque des revendications 1 à 3, caractérisé en ce que le premier noyau magnétique est revêtu d'une couche isolante (5).

5. Composant magnétique selon la revendication 4, caractérisé en ce que la couche isolante est réalisée par un émaillage en verre.

6. Composant magnétique selon la revendication 4, caractérisé en ce que la couche isolante est réalisée par dépôt d'une couche d'un matériau époxy.

7. Composant magnétique selon l'une quelconque des revendications 1 à 6, caractérisé en ce que les flasques (3,4) du premier noyau magnétique sont munis d'encoches (6) pour le passage des extrémités des enroulements.

8. Composant magnétique selon l'une quelconque des revendications 1 à 7, caractérisé en ce que les surfaces latérales ou les surfaces inférieures des flasques du premier noyau magnétique sont munies de terminaisons conductrices (7, 20) permettant l'accrochage des connexions métalliques sur le circuit magnétique.

9. Composant magnétique selon l'une quelconque des revendications 1 à 8, caractérisé en ce qu'il comporte de plus un deuxième noyau magnétique (12) électriquement isolé pour fermer le champ magnétique avec ou sans entrefer.

10. Composant magnétique selon l'une quelconque des revendications 1 à 9, caractérisé en ce que les noyaux magnétiques sont réalisés en ferrite doux.

11. Composant magnétique selon la revendication 10, caractérisé en ce que le ferrite doux est à base de Fe, Mn, Zn.

FIG.1

12
13
10
11
11A
1

FIG.2

13
12
1
3
4
11
9 10 2 8

FIG.3

FIG.4

FIG.5

FIG.6

FIG.7B

FIG.7A

**Office européen des brevets**

# RAPPORT DE RECHERCHE EUROPEENNE

Numero de la demande

EP 92 40 0423

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | PATENT ABSTRACTS OF JAPAN<br>vol. 14, no. 396 (E-970)(4339) 27 Août 1990<br>& JP-A-2 150 004 ( TOKO INC ) 8 Juin 1990<br>* abrégé *<br>--- | 1-4,9 | H01F15/02<br>H01F15/10 |
| A | EP-A-0 213 982 (BOYER)<br><br>----- | | |
| | | | **DOMAINES TECHNIQUES RECHERCHES (Int. Cl.5)**<br><br>H01F |

Le présent rapport a été établi pour toutes les revendications

| Lieu de la recherche | Date d'achèvement de la recherche | Examinateur |
|---|---|---|
| LA HAYE | 05 JUIN 1992 | BIJN E.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)